(19) Europäisches Patentamt
European Patent Office
Office européen des brevets

(11) **EP 4 174 504 B1**

(12) **FASCICULE DE BREVET EUROPEEN**

(45) Date de publication et mention
de la délivrance du brevet:
**10.07.2024   Bulletin 2024/28**

(21) Numéro de dépôt: **22202908.4**

(22) Date de dépôt: **21.10.2022**

(51) Classification Internationale des Brevets (IPC):
**G01R 31/367** (2019.01)      **G01R 31/392** (2019.01)

(52) Classification Coopérative des Brevets (CPC):
**G01R 31/367; G01R 31/392**

(54) **PROCEDE D'ETALONNAGE D'UN MODELE D'ESTIMATION DU VIEILLISSEMENT D'ACCUMULATEURS ELECTROCHIMIQUES**

**VERFAHREN ZUR KALIBRIERUNG EINES MODELLS ZUR ALTERUNGSSCHÄTZUNG VON ELEKTROCHEMISCHEN AKKUMULATOREN**

**METHOD FOR CALIBRATING AN AGING ESTIMATION MODEL OF ELECTROCHEMICAL ACCUMULATORS**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:  **27.10.2021   FR 2111401**

(43) Date de publication de la demande:
**03.05.2023   Bulletin 2023/18**

(73) Titulaire: **Commissariat à l'énergie atomique et aux énergies alternatives
75015 Paris (FR)**

(72) Inventeurs:
  • **HABER, Marc
    38054 Grenoble Cedex 9 (FR)**
  • **RACCURT, Olivier
    38054 Grenoble Cedex 9 (FR)**

(74) Mandataire: **Atout PI Laplace
Immeuble Up On
25 Boulevard Romain Rolland
CS 40072
75685 Paris Cedex 14 (FR)**

(56) Documents cités:
**US-A1- 2015 268 307**

• **EDDAHECH AKRAM ET AL: "Strategy for lithium-ion battery performance improvement during power cycling", IECON 2013 - 39TH ANNUAL CONFERENCE OF THE IEEE INDUSTRIAL ELECTRONICS SOCIETY, IEEE, 10 November 2013 (2013-11-10), pages 6806 - 6811, XP032538859, ISSN: 1553-572X, [retrieved on 20131230], DOI: 10.1109/IECON.2013.6700259**
• **DE HOOG JORIS ET AL: "Combined cycling and calendar capacity fade modeling of a Nickel-Manganese-Cobalt Oxide Cell with real-life profile validation", APPLIED ENERGY, ELSEVIER SCIENCE PUBLISHERS, GB, vol. 200, 12 May 2017 (2017-05-12), pages 47 - 61, XP085041687, ISSN: 0306-2619, DOI: 10.1016/J.APENERGY.2017.05.018**
• **SARASKETA-ZABALA E ET AL: "Realistic lifetime prediction approach for Li-ion batteries", APPLIED ENERGY, ELSEVIER SCIENCE PUBLISHERS, GB, vol. 162, 11 November 2015 (2015-11-11), pages 839 - 852, XP029327368, ISSN: 0306-2619, DOI: 10.1016/J.APENERGY.2015.10.115**
• **TIMMERMANS JEAN-MARC ET AL: "Batteries 2020 - Lithium-ion battery first and second life ageing, validated battery models, lifetime modelling and ageing assessment of thermal parameters", 2016 18TH EUROPEAN CONFERENCE ON POWER ELECTRONICS AND APPLICATIONS (EPE'16 ECCE EUROPE), JOINTLY OWNED BY IEEE-PELS AND EPE ASSOCIATION, 5 September 2016 (2016-09-05), pages 1 - 23, XP032985415, DOI: 10.1109/EPE.2016.7695698**

- PELLEGRINO LUIGI ET AL: "Aging test protocol for Lithium-ion cells", 2019 AEIT INTERNATIONAL ANNUAL CONFERENCE (AEIT), AEIT, 18 September 2019 (2019-09-18), pages 1 - 6, XP033647729, DOI: 10.23919/AEIT.2019.8893355
- STROE DANIEL ET AL: "Accelerated lifetime testing methodology for lifetime estimation of Lithium-ion batteries used in augmented wind power plants", 2013 IEEE ENERGY CONVERSION CONGRESS AND EXPOSITION, IEEE, 15 September 2013 (2013-09-15), pages 690 - 698, XP032516478, DOI: 10.1109/ECCE.2013.6646769
- SARASKETA-ZABALA E ET AL: "Validation of the methodology for lithium-ion batteries lifetime prognosis", 2013 WORLD ELECTRIC VEHICLE SYMPOSIUM AND EXHIBITION (EVS27), IEEE, 17 November 2013 (2013-11-17), pages 1 - 12, XP032654258, DOI: 10.1109/EVS.2013.6914730
- MATHIEU ROMAIN ET AL: "D-optimal design of experiments applied to lithium battery for ageing model calibration", ENERGY, ELSEVIER, AMSTERDAM, NL, vol. 141, 23 November 2017 (2017-11-23), pages 2108 - 2119, XP085312168, ISSN: 0360-5442, DOI: 10.1016/J.ENERGY.2017.11.130

**Description**

L'invention relève du domaine technique de l'estimation du vieillissement, et donc de la perte de performances, d'accumulateur électrochimiques, notamment du type Li-ion (Lithium-ion). Elle porte sur un procédé d'étalonnage d'un modèle d'estimation du vieillissement de tels accumulateurs et sur un procédé d'utilisation d'un tel modèle. L'invention s'applique en particulier, mais pas exclusivement, aux accumulateurs pour véhicules (terrestres ou autres) à propulsion électrique.

Les accumulateurs Li-ion représentent de nos jours les performances les plus favorables au niveau de leur usage dans les smart phones, objets électroportatifs ainsi les voitures électriques notamment les tout-électriques, les hybrides 48V et les hybrides rechargeables.

Reconnus comme une des solutions majeures pour le remplacement des énergies fossiles dans les transports, les batteries Li-ion représentent la voie la plus avancé dans la transition énergétique pour le stockage de l'énergie électrique. Cependant, les batteries Li-ion représentent une part importante du coût d'un véhicule (jusqu'à 40%). En conséquence leur durée de vie doit être importante et au moins égale à celle du véhicule pour amortir leurs coûts importants. Au cours de leur usage, les accumulateurs, rangés dans le pack batteries, vont subir des pertes de performances et donc impacter leurs durées de vie. Ce critère est donc primordial tant pour les constructeurs que pour l'usager quant au déploiement de cette technologie et son acceptation. Cependant, il faut noter que l'état de l'art actuel ne propose pas de méthodes d'estimation de durée de vie suffisamment pertinentes, la question de vieillissement et de son estimation demeure problématique. Par ailleurs les méthodes utilisées pour prédire la durée de vie des batteries sont basées sur des essais de vieillissement normés et des modèles associés. Modèles qui servent ensuite à l'établissement des algorithmes de prédictions intégré dans le système de gestion de batterie (en anglais, « battery management system », ou BMS). Si ces modèles de vieillissement sont établis sur la base d'essais non représentatifs de l'usage, les algorithmes de prédictions de durée de vie sont alors imparfaits et conduisent à une mauvaise estimation des dégradations des performances.

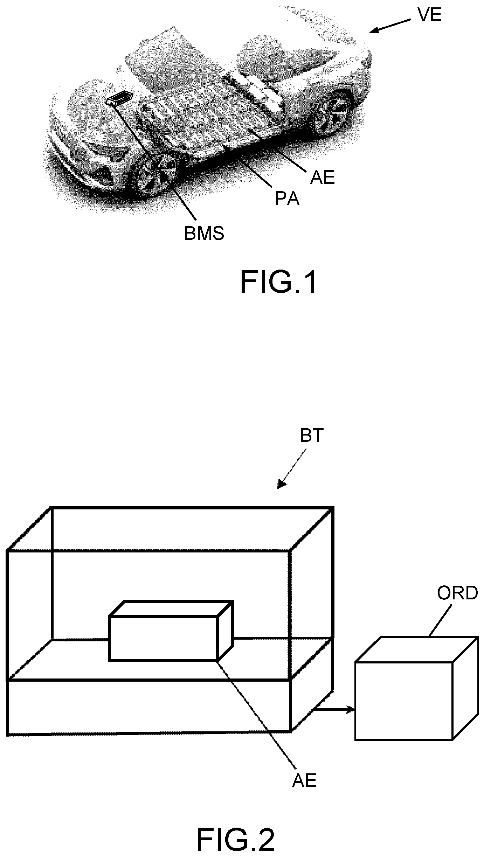

A titre d'exemple, la Fig. 1 illustre un véhicule électrique VE équipé d'un pack batterie PA comprenant une pluralité d'accumulateur électrochimiques AE piloté par un système de gestion de batterie BMS.

La Fig. 2 illustre un banc de test BT comprenant une enceinte à l'intérieur de laquelle peut être placé un accumulateur électrochimique AE. La température, et parfois l'hygrométrie, à l'intérieur de l'enceinte sont contrôlée par un ordinateur ORD. Des circuits électroniques (non représentés), contrôlés par l'ordinateur et connectés à l'accumulateur AE, permettent d'appliquer à ce dernier des sollicitations de charge et décharge, et de le soumettre à des tests de performance. Les résultats de ces tests sont ensuite utilisés par l'ordinateur pour estimer des paramètres d'un modèle de vieillissement. D'une manière plus générale, le contrôle du banc de mesure et l'estimation des paramètres du modèle de vieillissement peuvent être effectués par tout système de traitement numérique, par exemple un ou plusieurs ordinateurs, un processeur embarqué, un système en réseau etc.

A ce jour, des protocoles de vieillissements accélérés mis en place pour les accumulateurs lithium ion se basent sur la méthode appelée « surcontrainte » (« overstress » en anglais) et/ou la méthode « temps d'arrêt réduit » (« reduced off-time » en anglais), des méthodes expliquées en plus de détails dans [1].

Sachant que les principales contraintes ou sollicitations appliquées à un accumulateur sont la température et la sollicitation en charge et en décharge représentée par le courant (appelé également régime), l'état de charge (SOC pour « state of charge ») et la profondeur du cyclage (en charge et en décharge), la première méthode consiste à appliquer une valeur de stress plus élevée que les valeurs rencontrées en usage réel, ayant pour but d'accélérer les dégradations et donc la perte de performance. Les valeurs de stress les plus rencontrés dans la littérature ainsi que dans les normes sont la température (souvent prise à -20°C, 0°C et 45°C), le régime de charge, la profondeur de décharge ainsi que l'état de charge (SOC). La deuxième consiste à réduire les périodes d'arrêt, dans le cas automobile on parle de temps passé en stationnaire (calendaire). Les normes décrivent des profils d'usage type en charge ou bien en décharge dont les limites de SOC sont spécifiques. Les vieillissements proposés dans ces normes séparent le vieillissement calendaire du cyclage (deux protocoles distincts) et lors du cyclage celui-ci est effectué de façon continue, c'est-à-dire sans temps de pause entre chaque cycle. En effet dans le vieillissement des accumulateur Li-ion, on distingue deux modes de vieillissement qui engendrent des mécanismes de dégradation différents:

- Le premier mode correspond à l'accumulateur au repos, c'est-à-dire lorsqu'aucun courant ne le traverse. On appelle le temps passé dans cette état la phase calendaire et correspond à la situation d'un véhicule à l'arrêt.
- Le deuxième est lorsqu'il y a un échange de courant, en charge ou décharge.

C'est pourquoi les études de vieillissement dans la littérature sont basée principalement sur la dissociation de ces deux phases et conduit à l'utilisation de deux protocoles de vieillissement distincts, l'un en calendaire et l'autre en cyclage. La modélisation du vieillissement se fait donc dans l'hypothèse d'une simple addition des pertes de performances issues de ces deux phases. Cette approche, plus connue sous le nom de l'approche Palmgren-Miner, considère qu'il y a une indépendance des facteurs de stress entre les deux phases et donc dans notre cas une indépendance calendaire/cyclage. Or dans la réalité, ce n'est pas le cas. En effet, les phases de cyclage et de calendaire se déroulent successivement au cours de l'usage et il existe une interdépendance entre ces deux phases sur les dégradations de la cellule. Plusieurs études de la littérature montrent en effet que l'approche consistant à séparer le vieillissement calendaire et le cyclage lors des essais et d'établir un modèle basé sur une combinaison linaire de ces deux contributions ne permet pas de représenter ce qui est observé sur le terrain lors du suivi des flottes de véhicules. Par exemple, plusieurs résultats de la littérature montrent que cette méthode ne permet de modéliser correctement que le vieillissement des premiers mois d'usage réel. Après quoi les prédictions issues du modèle divergent rapidement des valeurs mesurées [2]. Ces résultats montrent donc clairement que la contribution des phases de calendaire et de cyclage ne peuvent être étudiées séparément pour ensuite être ajoutées lors de la modélisation du vieillissement et la prédiction de durée de vie.

Ce constat est partagé par la communauté du domaine. Un rapport de la commission européenne [3], invite à mettre en place un nouveau protocole de vieillissement qui adresses différentes lacunes dans le domaine actuel, en citant les deux problématiques ci-dessous.

Les protocoles actuels engendrent bien une perte de performance de façon accéléré par une sollicitation supérieure à l'usage (surcontrainte), mais dans la majorité des cas les mécanismes de dégradation engendrés sont différent de ceux observés dans l'usage. Ce qui remet en cause la pertinence de ces protocoles.

De même, les protocoles mentionnés sont décolérés de l'application, dans ce cas un usage automobile, dans lequel les vieillissements en cyclage et calendaire coexistent. Des publications ont montré qu'il y a une dépendance non linéaire calendaire/cyclage, donc séparer les deux phases dans les protocoles de vieillissements accélérés semble être une raison majeure de l'imprécision de l'estimation de durée de vie [4].

Les documents [5], [6], [7], [8], [9], [10] et [11] divulguent des modèles de vieillissement dans lequel un vieillissement total est calculé comme combinaison linéaire de contributions correspondant à différentes sollicitations.

Le document [12] divulgue l'utilisation d'un premier modèle d'étalonnage prenant en compte uniquement le vieillissement calendaire et d'un deuxième modèle de vieillissement combinant vieillissement calendaire et vieillissement induit par le cyclage.

L'invention vise à surmonter les inconvénients précités de l'art antérieur.

Conformément à l'invention, ce but est atteint grâce à une nouvelle méthodologie de vieillissement accélérée et à une modélisation associée permettant d'estimer la durée de vie d'un accumulateur, notamment mais pas exclusivement en technologie Li-ion. Cette méthodologie se base en particulier sur les typologies d'usage effectivement constatées et permet ainsi une approche plus pertinente du vieillissement et de l'estimation de durée de vie. Cela permet d'établir des algorithmes de prédiction de vieillissement intégrés au BMS plus performants et améliore de ce fait la prédiction en temps réelle de la durée de vie.

L'invention peut par exemple être mise en oeuvre au moyen d'un banc de test du type illustré sur la Fig. 2.

Un objet de l'invention est un procédé d'étalonnage d'un modèle d'estimation du vieillissement d'accumulateurs électrochimiques, comprenant les étapes suivantes :

a) soumettre des accumulateurs électrochimiques à au moins une première phase de vieillissement pendant laquelle ils sont soumis à un premier type de sollicitation, un test de performance desdits accumulateurs étant réalisé après ladite ou chaque dite phase ;
b) à partir des résultats du ou des tests de performance effectués lors de l'étape précédente, estimer des paramètres d'un premier modèle élémentaire de vieillissement au moyen d'un système de traitement numérique ;
c) soumettre les accumulateurs électrochimiques à au moins une deuxième phase de vieillissement, ladite ou chaque dite deuxième phase de vieillissement comprenant une période pendant lesquelles ils sont soumis audit premier type de sollicitation, suivie d'une période pendant lesquelles ils sont soumis à un deuxième type de sollicitation, différent du premier, un test de performance desdits accumulateurs étant réalisé après ladite ou chaque dite phase ;
d) à partir des résultats du ou des tests de performance effectués lors de l'étape précédente, estimer des paramètres d'un deuxième modèle élémentaire de vieillissement au moyen dudit ou d'un autre système de traitement numérique ; caractérisé en ce que le modèle d'estimation du vieillissement d'accumulateurs électrochimiques comprend le premier et le deuxième modèle élémentaire.

Un autre objet de l'invention est un procédé d'estimation du vieillissement d'un accumulateur électrochimique au moyen d'un modèle obtenu au moyen d'un tel procédé d'étalonnage, comprenant les étapes suivantes :

I) déterminer un type de sollicitation, utilisé lors de l'étalonnage du model, auquel est soumis l'accumulateur et sélectionner le modèle élémentaire correspondant ;
II) estimer le vieillissement dudit accumulateur par application du modèle élémentaire sélectionné ;

lesdites étapes étant mises en oeuvre par un système de gestion de batterie (BMS).

D'autres caractéristiques, détails et avantages de l'invention ressortiront à la lecture de la description faite en référence aux dessins annexés donnés à titre d'exemple et qui représentent, respectivement :

Fig.1, déjà décrite, un véhicule électrique équipé d'accumulateurs électrochimiques ;

Fig. 2, déjà décrite, un banc de test pour accumulateurs électrochimiques ;

Fig. 3, un schéma illustrant un principe général à la base de l'invention ;

Fig. 4, des protocoles de vieillissement accéléré et caractérisation d'accumulateurs électrochimiques selon un mode de réalisation particulier de l'invention ;

Fig. 5, un schéma illustrant l'estimation du vieillissement et de ses différentes contributions selon un mode de réalisation particulier de l'invention.

L'invention sera décrite en référence au cas des accumulateurs Li-ion utilisés dans les voitures électriques. Elle est cependant d'application plus générale et peut concerner tout objet utilisant un accumulateur, sujet à du vieillissement lié à différents types d'usages (véhicule électrique - terrestre, aquatique ou aérien ; outil électroportatif ; batteries de secours, etc..). L'invention n'est d'ailleurs pas limitée à la technologie Li-ion.

La méthodologie à la base de l'invention s'appuie sur une analyse de l'usage auxquels est soumis l'accumulateur afin d'extraire les différentes phases correspondant aux différents types de sollicitations auxquels il est soumis, contribuant de manière différente à son vieillissement.

A partir des phases typiques d'usage, et donc de vieillissement, ainsi identifiées, des protocoles de vieillissements accélérés représentatifs sont établis afin d'analyser le comportement des accumulateurs dans chacune de ces phases, ce qui permet d'établir un modèle de vieillissement associé.

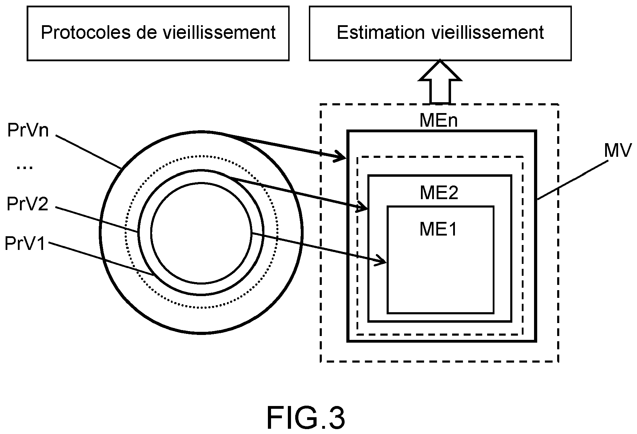

Ces protocoles sont construits suivant une démarche en « couches », illustrée par la Fig. 3.

Le premier protocole de vieillissement PrV1 correspond à l'usage principale de l'accumulateur défini comme étant celui qui introduit le plus de vieillissement soit parce que c'est la sollicitation principale en terme temporelle, soit parce que c'est la plus dommageable. Cette première phase permet de construire un premier modèle élémentaire de vieillissement ME1.

Un deuxième protocole de vieillissement PrV2 est construit en ajoutant à la première sollicitation une deuxième sollicitation correspondant à un usage secondaire de l'accumulateur, cette deuxième sollicitation étant de préférence la deuxième en termes d'importance de son impact sur le vieillissement. La sollicitation globale appliqués ici prend en compte la proportion et la fréquence des deux sollicitations pour construire un protocole de vieillissement accéléré représentatif. Les sollicitations sont appliquées de façon successive et répétitives avec une temporalité représentative de l'usage réelle. Cette deuxième étape permet de construire un deuxième modèle élémentaire de vieillissement intégrant les deux types de sollicitation de façon couplée.

Ensuite, on peut ainsi procéder de la même façon en rajoutant autant de protocoles de vieillissement PrV1, PrV2, ...PrVn que nécessaire, correspondant aux différents usages et types de sollicitations identifiés, sachant que cette intégration se fait non pas de façon linéaire mais intégrative, c'est-à-dire que chaque nouvelle phase intègre dans son protocole de sollicitation les sollicitations des phases précédentes. Cela conduit à un nombre correspondant de modèles élémentaires ME1, ME2, ... MEn, dont l'union constitue le modèle de vieillissement MV complet. L'ordre dans lequel les différents types de sollicitations sont introduits est préférentiellement choisi, pour les contributions les plus significatives, dans l'ordre décroissant de l'impact des contributions vis-à-vis du vieillissement global.

A titre d'exemple, une mise en oeuvre complète de la méthodologie sera décrite pour le cas particulier des accumulateurs des véhicules terrestres (automobiles) tout-électriques, aussi connu sous le nom de BEV (pour « Battery Electric Vehicle »). Celle-ci se développe en quatre étapes, de l'étude de l'usage jusqu'à l'intégration potentielle dans un BMS.

La première étape de la méthode est une étude de l'usage des accumulateurs afin d'identifier les différentes phases ou typologies de vieillissement ainsi que, préférentiellement, une estimation grossière de l'impact des différents types de sollicitations au vieillissement global, dans le contexte d'usage considéré

Cette étude permet de distinguer trois types de sollicitations, ou typologie de vieillissement et d'estimer leur contribution au vieillissement global. La plus fréquente et impactante, correspondant au premier type de sollicitation S1, est le stationnement ; on parle alors de « vieillissement calendaire ». Le véhicule en effet passe plus de 90% de sa vie en stationnaire [3], dont on peut distinguer des phases inactives, en plus grande partie, où le véhicule est garé avant le premier trajet de la journée, et des phases actives, où le véhicule est garé entre deux trajets consécutifs. Le deuxième type de sollicitation S2, seconde contribution la plus importante au vieillissement dans le cas d'usage considéré, correspond aux courts trajets (<10km). Plus de 70% des trajets effectués en Europe sont en effet des trajets inférieurs à 10km et environ 34% de navetteurs français habitent à moins que 10km du lieu de travail. Le troisième type de sollicitation S3 correspond aux longs trajets (entre 10 et 20km), troisième contribution la plus importante au vieillissement dans le cas d'usage considéré. En effet, 10 à 20% représente la part de trajets effectués sur les territoires Européens, et 30% représente la part des navetteurs français qui résident à moins de 20km de leurs travails. Les trajets plus longs sont effectués moins fréquemment et donc ne vont pas faire l'objet du protocole.

La deuxième étape correspond à l'application de la méthode « à plusieurs couches » dont le principe a été exposé plus haut en référence à la Fig. 3. Un protocole de vieillissement PrV est défini pour chacune des trois types de sollicitation identifiés lors de l'étape précédente. Aussi, le protocole de vieillissement PrV1 correspond à une ou (préférentiellement) plusieurs itérations d'une première phase de vieillissement PV1 incluant uniquement la première sollicitation S1 ; le protocole PrV2 correspond à une ou (préférentiellement) plusieurs itérations d'une deuxième phase de vieillissement PV2 incluant la première sollicitation S1 et la deuxième sollicitation S2 et ainsi de suite jusqu'au protocole de vieillissement PrVn qui correspond à une ou (préférentiellement) plusieurs itérations d'une n-ème phase de vieillissement comprenant les sollicitations S1 ...Sn. Comme cela sera détaillé plus loin, une phase de vieillissement peut également comprendre une recharge. Dans certains cas d'usage, cette recharge peut également s'appliquer à la première phase de vieillissement.

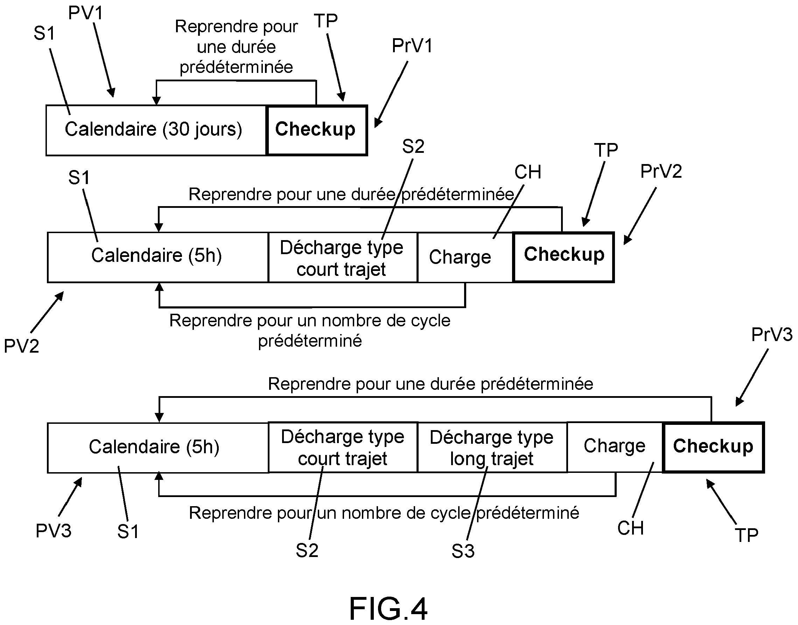

Comme illustré sur la Fig. 4, la première phase de vieillissement PV1, qui consiste à faire vieillir l'accumulateur en calendaire à des valeurs de SOCs (c'est-à-dire des états de charge) et des valeurs de températures différentes. Il s'agit là du premier, et plus important, type de sollicitation S1. Pour cela la cellule est placée dans un état de charge donné, puis laissée en l'état à température constante. Des tests de performance (ou « checkups ») TP sont effectués à l'issue d'une durée déterminée (par exemple 30 jours) de la phase de vieillissement PV1 pour quantifier les mécanismes de dégradation. Le premier protocole de vieillissement PrV1 comprends une ou (de préférence) plusieurs itérations du couple première phase de vieillissement calendaire - test de performance pour une durée prédéterminée.

Le deuxième protocole de vieillissement PrV2 comprend une ou plusieurs itérations d'une deuxième phase de vieillissement PV2 consistant à faire vieillir la batterie en alternant la phase calendaire pour 5h, identiques à l'étape calendaire précédente - sollicitation S1 - (mais de durée moindre), suivie d'une deuxième sollicitation S2 par cyclage de courte durée, équivalent à 10km de roulage (par exemple 15 min pour une vitesse moyenne de 40 km/h) à puissance constante, puis d'une recharge CH. L'alternance S1 - S2 - CH est itérée un nombre de fois prédéterminés avant la réalisation d'un test de performances TP. Le tout est répété pendant une durée prédéterminée. Une durée de cinq heures a été affectée à chaque phase calendaire afin de garder la part de roulage (5% de l'usage totale) identique à celle de l'usage réel. Les checkups TP permettent de quantifier les dégradations dues à une combinaison des courts trajets et du vieillissement calendaire.

Le troisième protocole PrV3 comprend une ou (de préférence) plusieurs itérations d'une troisième phase de vieillissement PV3 consiste à alterner les trois sollicitations (S1 : calendaire ; S2 : courts trajets ; S3 : longs trajets) et charge CH, avec encore une fois des tests de performance périodiques permettant de quantifier les dégradations dues à une combinaison des longs trajets, des courts trajets et du vieillissement calendaire.

Ces trois protocoles de test sont appliquées à des accumulateurs distincts mais identiques (issus d'un même lot par exemple). Le nombre d'accumulateur testé pour chacun des types de test doit être suffisant pour établir une statistique représentative et au minimum de 3.

Les différentes sollicitations S1, S2 et S3 sont définies par des valeurs de puissance fournie par l'accumulateur (sauf pour le vieillissement calendaire S1), température et niveau de SOC. Les valeurs de puissance choisies doivent être en lien avec la demande de puissance du véhicule.

Les voitures tout électriques, BEV, utilisent uniquement le pack batterie comme source d'énergie primaire pour se déplacer. La batterie est aussi chargée de délivrer l'énergie pour les éléments auxiliaires de la voiture, notamment la thermalisation du pack batterie, chauffage et climatisation de l'habitacle, l'interface utilisateur, les feux de signalisation, l'autoradio, le système de navigation et tous les organes de confort et de sécurité. Les éléments de thermalisation représentent une augmentation dans les ordres de 20% à 30% de la consommation d'énergie.

Ces valeurs seront donc dépendantes de la température ambiante. Il a été prouvé que la demande de puissance minime est aux alentours de 20°C. Par contre dans les cas de températures extrêmes, la thermalisation du pack et de la cabine se mettront en marche, et donc la demande de puissance augmentera. Pour les longs trajets les valeurs de puissances doivent être en lien avec la consommation à différents types de sollicitations (autoroutes, urbain et mixte).

Les valeurs de températures basses et élevées, et de puissances élevées, serviront dans le protocole de test à accélérer le vieillissement. Il est important de bien définir ces valeurs. En effet prendre des valeurs trop élevées, si elles accélèrent encore plus la perte de performance, engendrerait des mécanismes de dégradation qui ne se retournent pas en cas d'usage réel. C'est pour cette raison qu'on se contente d'accélérer le protocole en utilisant des valeurs extrêmes issues de l'analyse de l'usage.

Le tableau 1 ci-dessous indique les sollicitations à appliquer dans les différents protocoles de vieillissement accéléré.

[Table 1]

| Type de sollicitation | Température | SOC | Puissance | Durée |
|---|---|---|---|---|
| **S1 Calendaire** | Choisir les températures qui correspondent aux conditions extrêmes et une à la médiane e.g. 0°C - 20°C - 45°C | Choisir trois valeurs au minimum e.g. 50% - 70% - 90% | - | - |
| **S2 Courts trajets** | Garder les mêmes conditions du vieillissement en calendaire | En commençant la phase de décharge par le SOC en calendaire | Trois valeurs de puissance en lien avec la consommation du véhicule e.g. 300 Wh/km pour le climat froid 170 Wh/km pour le climat tempéré 240 Wh/km pour le climat chaud | Durée estimé pour un trajet inférieur à 10km, donc environ 15min |
| **S3 Longs trajets** | Garder les mêmes conditions du vieillissement en calendaire | A compléter par le SOC atteint dans la stratégie de court trajet | Trois valeurs de puissance en lien avec le type de trajet du véhicule : Autoroute 200 Wh/km Urbain 140 Wh/km Mixte des deux 170 Wh/km | Durée de 15min additionnelle à la stratégie précédente |

Le tableau 2 détaille la mise en oeuvre des différents protocoles de vieillissement PrV1, PrV2, PrV3. Le EOL (« End of Life », c'est-à-dire « fin de vie ») est la valeur d'un critère de performance prédéfini, obtenu pendant les tests de performance, qui indique que la batterie a atteint sa fin de vie. Dans le tableau, l'acronyme OCV désigne la tension de circuit ouvert de la batterie (« Open Circuit Voltage » en anglais).

[Table 2]

| Protocole de vieillissement | Etape | Mise en oeuvre |
|---|---|---|
| PrV1. Calendaire | 1 | Atteindre le niveau de SOC sélectionné (trois valeurs de SOC minimum) |
| | 2 | Stabiliser à la température donnée (trois valeurs de température) |
| | 3 | Garder à OCV pour 30 jours |
| | 4 | Checkup pour caractérisation des performances |
| | 5 | Reprendre depuis l'étape 1 de la phase PV1 Arrêt du test après avoir atteindre le niveau de fin de vie (EOL) |

(suite)

| Protocole de vieillissement | Etape | Mise en oeuvre |
|---|---|---|
| PrV2. Calendaire + court trajets | 1 | Reprendre les étapes 1 et 2 de la phase PV 1 |
| | 2 | Garder à OCV pour 4h |
| | 3 | Garder la températures de la phase calendaire (PV1), et décharge à la puissance équivalente à la température donnée pour 15 min |
| | 4 | Charge jusqu'au SOC équivalent |
| | 5 | Reprendre l'étape 2 pour la durée de 30 jours |
| | 6 | Checkup pour caractérisation des performances |
| | 7 | Reprendre depuis l'étape 1 de la phase PV2<br>Arrêt du test après avoir atteindre le niveau de fin de vie (EOL) |
| PrV3. Calendaire + court trajets + longs trajets | 1 | Reprendre l'étape 1 de l'étape PV1 |
| | 2 | Reprendre les étapes 2 et 3 de l'étape PV2 |
| | 4 | Décharge équivalente au type de trajet pour une durée additionnelle à 15min |
| | 5 | Charge jusqu'au SOC équivalent |
| | 6 | Reprendre l'étape 2 pour la durée de 30 jours |
| | 7 | Checkup pour caractérisation des performances |
| | 8 | Reprendre depuis l'étape 1 de l'étape PV3<br>Arrêt du test après avoir atteindre le niveau de fin de vie (EOL) |

Concernant les tests de performance TP périodiques évoqués ci-dessus, différentes méthodologies sont décrites en fonction du critère de performance. Le critère de performance dépend cependant de l'application. Pour les batteries types énergie, le critère de performance principal est la quantité d'énergie en Wh restante dans la cellule. Alors que pour les batteries types puissance, la valeur de puissance pour une impulsion de courant donné représente le critère de performance à étudier. La méthode de mesure des critères de performance est décrite soit dans la feuille technique issue du fabricant de l'accumulateur, soit dans les normes comme élaboré dans le tableau 3 ci-dessous, basé sur la norme USABC pour BEV, Révision 3, 2015. Tandis que la périodicité des tests de performance peut se faire mensuellement (une fois tous les 30 jours) ou bien en terme de cycle dans les cas où la stratégie évoque des cas de roulage (e.g. tous les 100 cycles). La fréquence doit être choisie de sorte à ce que les tests n'affectent pas le vieillissement de la cellule.

La définition des protocoles de test donnée ci-dessus peut varier en fonction du type de modélisation utilisé ainsi que du type de batterie testée. Ils sont donnés à titre d'exemple.

[Table 3]

| Paramètre | Protocole issue de USABC pour BEV Rev 3 2015 |
|---|---|
| Energie (Wh) | T(°C): 30°C<br>$I_{discharge}$: C/3 |
| Puissance (W) | T°C : 30°C<br>$I_{pulse}$ : 1C pour 30s |

Dans l'expression C/n, « C » désigne la capacité de la batterie en Ah et n un temps en heures.

La troisième étape de la méthode consiste à utiliser les résultats des tests de performance obtenus par les trois protocoles de vieillissement pour estimer les paramètres des modèles élémentaires ME1, ME2, ME3. Cette étape est mise en oeuvre par un ou plusieurs systèmes de traitement numérique, par exemple l'ordinateur ORD du banc d'essai de la Fig. 2. Elle peut être mise en oeuvre en une seule fois après que tous les protocoles de vieillissement ont été mis en oeuvre, ou séparément pour chaque protocole.

Afin d'estimer la durée de vie de l'accumulateur dans le véhicule, un modèle empirique illustrant l'évolution d'énergie à travers des équations de vieillissements est utilisé à titre d'exemple. Trois équations sont mises en place pour modéliser :

- le vieillissement en calendaire (cal), ce qui correspond à la phase de vieillissement PV1 et donc à la sollicitation S1 ;
- le vieillissementen court trajet (ST, pour Short Trip), ce qui correspond à la phase de vieillissement PV2 et donc à l'application combinée des sollicitations S1 et S2 ; et
- le vieillissement en long trajet (LT, pour Long Trip), ce qui correspond à la phase de vieillissement PV3 et donc à l'application combinée des sollicitations S1, S2 et S3.

$$E_{cal}^{loss}(Wh) = f(T, SOC, t) = k_{cal}^{T}(T) \cdot k_{cal}^{SOC}(SOC) \cdot k_{cal}^{t}(t)$$

$$E_{ST}^{loss}(Wh) = f(T, SOC_{ini}, P, E_{dch}) = k_{ST}^{T}(T) \cdot k_{ST}^{SOC_{ini}}(SOC_{ini}) \cdot k_{ST}^{P}(P) \cdot k_{ST}^{E_{dch}}(E_{dch}) \cdot k_{cal}^{t}(t)$$

$$E_{LT}^{loss}(Wh) = f(T, SOC_{ini}, P, E_{dch}) = k_{LT}^{T}(T) \cdot k_{LT}^{SOC_{ini}}(SOC_{ini}) \cdot k_{LT}^{P}(P) \cdot k_{LT}^{E_{dch}}(E_{dch}) \cdot k_{cal}^{t}(t)$$

Dans ces équations, Wh désigne l'unité d'énergie Watt-heure, $E^{loss}_{i}$ la perte d'énergie dans le régime « i » (« i » prenant les valeurs « cal », « ST », « LT »), T la température, SOC l'état de charge, t le temps, $E_{dch}$ la quantité d'énergie déchargée, $SOC_{ini}$ l'état de charge initial, P la puissance fournie par l'accumulateur.

Les paramètre k du modèle représentent l'impact des facteurs de stress sur le critère de performance (ici $E^{loss}_{i}$). Cet impact s'exprime à l'aide d'une équation de vieillissement qui peut prendre la forme d'une fonction de type Arrhenius (par exemple : $k_{cal}(T) = exp\left(-\frac{\alpha_1}{\alpha_2 T}\right)$ ) comme elle peut aussi s'exprimer par un fonction polynomiale (par exemple : $k_{ST}^{SOC_{ini}}(SOC_{ini}) = \beta_1 * SOC_{ini} + \beta_1$ ) mais aussi à l'aide d'une loi de puissance (par exemple : $k_{LT}^{E_{dch}}(E_{dch}) = \gamma_1 * E_{dch}^{\gamma_2}$ ). Dans les équations précédentes les facteurs écrits en caractère grecs ici représentent des paramètres identifiés par un ajustement entre les courbes de charge et de décharge du modèle prédictif et des campagnes de checkups. Plusieurs méthodes peuvent être utilisées pour cela, notamment la méthode Levenberg-Marquardt. Celle-ci est un algorithme itératif utilisé pour minimiser l'erreur des moindres carrés entre les données expérimentales et une fonction objective (but optimal). Les étapes ci-dessous décrivent la méthode itérative de façon globale :

- Générer des valeurs initiales pour les paramètres d'ajustement k (commençant par une estimation initiale et des limites de bornes supérieures et inférieures).
- Calculer une première valeur de $E_{cal}^{loss}, E_{ST}^{loss}$ et $E_{LT}^{loss}$.
- Calculer l'erreur des moindres carrés entre les valeurs estimées par le modèle, étape ii, et la valeur obtenue des campagnes de test pour les trois types de sollicitation Cal, ST et LT.
- Si l'erreur n'a pas atteint son minimum, retour à la première étape avec une estimation de nouveaux paramètres établie normalement par des programmes d'optimisation conçu pour ce genre d'application

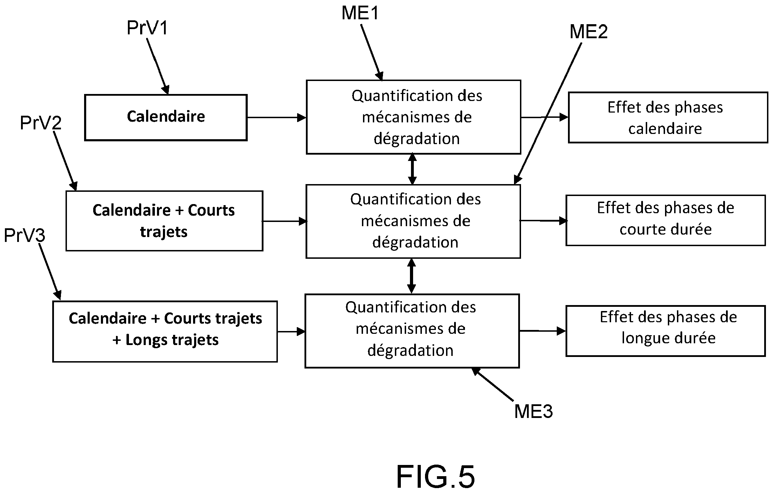

La quatrième étape, mise en oeuvre par un BMS dans le cas d'un véhicule électrique en opération, consiste à déterminer le type de sollicitation auquel est soumis l'accumulateur, et à réaliser une estimation prédictive de son vieillissement en appliquant le modèle approprié. Par exemple, si le véhicule est garé, le vieillissement de la cellule suivra le premier modèle empirique, dans le cas où l'utilisateur de la voiture décide de faire un trajet court, donc inférieur à 10km, le vieillissement suivra le deuxième modèle et dans le cas où un plus long trajet se fait, le vieillissement suivra le troisième modèle. Par différence entre les quantifications des mécanismes de dégradation correspondant aux différents modèles élémentaires il est également possible de distinguer les effets des différentes sollicitations : calendaires, courts trajets, longs trajets. Cela est illustré par la Fig. 5.

Le modèle de vieillissement établi sur la base des différentes phases représentatives de l'usage peut ainsi servir de base algorithmes de prédiction de durée de vie spécifique à chacun des usages. Ces algorithmes peuvent être intégrés au BMS afin d'évaluer plus précisément la durée de vie des accumulateurs. En particulier, les données de suivi du véhicule permettent à l'aide du BMS et éventuellement d'un soutien via une intelligence artificielle de déterminer précisément l'usage subi par les accumulateurs en temps réel. A partir des modèles précédemment établis lors des vieillissements accélérés il est donc possible d'avoir une meilleure estimation de l'état de santé des accumulateurs et de la prédiction de durée de vie.

On peut également citer le fait que ces algorithmes de prédiction de durée de vie embarqués dans le BMS peuvent en fonction de l'usage s'auto-adapter puisque les modèles établis préalablement lors des campagnes de vieillissement accélérés seront spécifiques à chaque typologie d'usage.

Par exemple un conducteur A ayant un usage principalement composé de trajets courts (usage urbain) conduira à un certain vieillissement. Si le véhicule change de propriétaire au milieu de sa vie avec un usage principalement sur des longs trajets, la détection par le BMS de ce changement d'usage permettra d'adapter les algorithmes de prédiction de durée de vie mais également les paramètres de gestion de la batterie afin de minimiser les vieillissements (e.g. évolution des paramètres issus des analyses ICA (de l'anglais « Incremental Capacity Analysis » c'est-à-dire analyse de capacité incrémentale, voir ci-après).

De la même façon lorsque le véhicule (ou la batterie) est en fin de vie et qu'il se pose la question de la seconde vie ou du recyclage des accumulateurs, les données récoltées ainsi que l'adaptation des algorithmes de prédiction de durée de vie au cours du temps sont autant d'information qui permettrons d'une part de faire un choix plus pertinent entre une seconde vie ou un recyclage. Dans le cas d'une seconde vie, une adaptation des algorithmes de prédiction de durée pourra être mis à jours suivant la même méthodologie vis-à-vis du nouvel usage.

L'invention a été décrite en référence à un mode de réalisation particulier, mais de nombreuses variantes sont possibles.

Par exemple, les véhicules hybrides (HEV) connaissent un profil d'usage spécifique, souvent appelé mode CS (pour Charge Sustaining). Durant ce mode, la batterie est sollicitée de façon à ce qu'elle assiste le moteur durant les phases d'accélération, ou bien aussi pour alimenter les auxiliaires tel que la thermalisation du pack ou de la cabine, les phares etc. Un tel profil pourra être utilisé comme variation de puissance lors de phases de roulage. Durant ce mode CS, le SOC de l'accumulateur alterne entre des valeurs de 40 et 60%. Ce qui fait que les SOC choisies durant le vieillissement calendaire doivent nécessairement être dans cette plage. Les tableaux 4 et 5 correspondent aux tableaux 1 et 2 mais pour des véhicules hybrides.

[Table 4]

| Type de sollicitation | Température | SOC | Puissance | Durée |
|---|---|---|---|---|
| S1 Calendaire | Choisir les températures qui correspond au conditions extrêmes et une à la médiane e.g. -5°C - 20°C - 45°C | Choisir trois valeurs au minimum entre 40% et 60% de SOC | - | - |
| S2 Courts trajets | Garder les mêmes conditions du vieillissement en calendaire | SOC variable entre SOC40 et SOC60 | Variation de puissance type de véhicule HEV | Durée de 15min |
| S3 Longs trajets | Garder les mêmes conditions du vieillissement en calendaire | SOC variable entre SOC40 et SOC60 | Variation de puissance type de véhicule HEV | Durée de 15min additionnelle à la stratégie précédente |

[Table 5]

| Phase de vieillissement | Etape | Mise en oeuvre |
|---|---|---|
| PV1. Calendaire | 1 | Atteindre le niveau de SOC sélectionné (trois valeurs de SOC minimum) |
| | 2 | Stabiliser à la température donnée (trois valeurs de température) |
| | 3 | Garder à OCV pour 30 jours |
| | 4 | Checkup pour caractérisation des performances |
| | 5 | Reprendre depuis l'étape 1 de la stratégie phase PV1 Arrêt du test après avoir atteindre le niveau de fin de vie |
| PV2. Calendaire + court trajets | 1 | Reprendre les étapes 1 et 2 de la phase PV 1 |
| | 2 | Garder à OCV pour 4h |
| | 3 | Garder la températures de la phase calendaire, et décharge suivant un cycle typique de HEV, pour 15 min |
| | 4 | Charge à régime C/3 jusqu'au SOC équivalent |
| | 5 | Reprendre l'étape 2 pour la durée de 30 jours, ou bien pour 100 cycles |
| | 6 | Checkup pour caractérisation des performances |
| | 7 | Reprendre depuis l'étape 1 de la phase PV2 Arrêt du test après avoir atteindre le niveau de fin de vie |
| PV3. Calendaire + court trajets + longs trajets | 1 | Reprendre l'étape 1 de la phase PV2 |
| | 2 | Reprendre les étapes 2 et 3 de la phase PV2 |
| | 3 | Stabiliser la température à 25°C dans le cas de la présence d'un BTMS liquide actif (BTMS : système de gestion thermique de batterie) |
| | 4 | Décharge type HEV pour une durée additionnelle à 15min |
| | 5 | Charge à régime C/3 jusqu'au SOC équivalent |
| | 6 | Reprendre l'étape 2 pour la durée de 30 jours, ou bien pour 100 cycles |
| | 7 | Checkup pour caractérisation des performances |
| | 8 | Reprendre depuis l'étape 1 de la phase PV3 Arrêt du test après avoir atteindre le niveau de fin de vie |

Le protocole pour les cellules des PHEV devrait se faire en prenant en considération les deux types de test BEV, pour des niveaux de SOCs entre 90 et 40%, et des tests type MHEV pour des niveaux de SOCs entre 40 et 20%.

On peut également pousser l'analyse jusqu'à utiliser des méthodes de test de performances, et donc des modèles de vieillissement, plus avancées permettant de quantifier les mécanismes de dégradation au sein de la cellule. Une liste non-exhaustive de ces méthode inclus des analyses ICA (pour Incremental Capacity Analysis), DVA (Diverential Voltage Analysis) et des spectroscopies d'impédance. A titre d'exemple, des analyses ICA permettent la quantification de la perte de Lithium (nommé LLI pour Loss of Lithium Inventory) et la perte de matière active (nommée LAM pour Loss of Active Material) pour les deux électrodes négatives (LAMNE) et positive (LAMPE) dû à des mécanismes de dégradation comme, par exemple, la couche de passivation sur la surface électrode négative-électrolyte (plus connue sous le nom de SEI, pour Solid Electrolyte Interphase) ou bien la dissolution des métaux de l'électrode positive. Pour obtenir des analyses ICA, durant les phases de checkups, un cycle en charge et décharge avec des courants faibles (dans l'ordre de C/20) permet de tracer l'évolution de la dérivée en tension de la capacité chargée/déchargée en fonction de la tension. L'évolution des piques de cette courbe permet de quantifier la perte de lithium et/ou de matériaux actifs.

En corrélant l'évolution du paramètre LLI, LAMNE et LAMPE avec les facteurs de stresses, on peut obtenir un modèle de dégradation prédictif dépendamment de chaque typologie de vieillissement, comme le montre la figure ci-dessous.

A titre d'exemple, le protocole de vieillissement calendaire induit principalement une augmentation du facteur LLI, attribuable à l'épaississement de la SEI ; et un changement négligeable des facteurs LAMNE et LAMPE. Le protocole de "vieillissement calendaire + court trajet" induit une augmentation du LLI moins aggravante que le protocole en calendaire mais une augmentation plus accentuée de la LAMPE. Ceci souligne l'effet des courts trajets en lien avec la puissance appliquée sur la cellule. Dans ce cas purement illustratif, c'est une perte des matériaux actifs à la positive, avec un épaississement moins important de la SEI.

Les analyses ICA sont intéressantes comme elles sont utilisées de nos jours dans le BMS, d'où l'intérêt d'y implémenter de cette méthodologie, mais plusieurs analyses existent pour quantifier les mécanismes de dégradation dans les accumulateurs Li-ion.

La méthode selon l'invention peut être utilisée au niveau d'un accumulateur individuel ou bien du pack batterie entier, en ajustant les valeurs de puissance.

Les conditions des phases de vieillissement doivent être adaptées conditions climatiques qui dépendent de la situation géographique. En effet, les conditions climatiques et l'usage n'est pas le même aux Etats-Unis et en Europe par exemple et autour du globe les conditions climatiques ne sont pas uniformes.

De même, les valeurs en temps et distance de courts trajets et longs trajets dans ce protocole sont basées sur des études Européennes, un usage qui favorise les trajets de courtes distances. Par contre dans le cas où ce protocole devrait s'appliquer dans un territoire qui favorise les longs trajets, à titre d'exemple les Etats Unis, les valeurs devront être adaptées en suivant la même méthodologie basé sur l'analyse de l'usage.

Dans le cas d'un usage spécifique comprenant plus de trois phases distinctes (comme décrit ici : calendaire, court trajet et long trajet) la méthodologie peut également être appliquée en ajoutant autant de phases que nécessaire.

La même méthodologie est applicable à tout type de véhicule électrique. Par contre une analyse de l'usage permettant de connaitre précisément les différentes phases (calendaire, court trajet, long trajet) sera nécessaire afin de définir les plages et les niveaux de sollicitations associées ainsi que leur part respective de contribution estimée au vieillissement global et ainsi adapter les conditions de test, voire l'ordre de prise en compte des sollicitations. On pense notamment à des véhicules non terrestres (ULM, Taxi volant, drones, etc...) mais également aux engins spatiaux. En effet, dans ce dernier genre d'application les facteurs environnementaux ainsi que le mode opératoire peuvent être différents, par contre la méthodologie reste identique. Cette dernière peut aussi être utilisé dans le domaine des piles à combustible.

Cette métrologie peut aussi s'appliquer à des objets électrifiés contenant une batterie Li-ion (voire basée sur une autre technologie) tels que les objets électroportatifs. Cependant là encore une analyse de l'usage doit être effectuée pour déterminer les conditions spécifiques du protocole de test. Par contre la division entre une phase de calendaire et une ou deux phases combinées calendaire et usage court et long est aussi pertinente.

Références

(1) Wayne Nelson "Accelerated Testing " 1991, Wiley, ISBN 9780471522775 - Chapitre 1.

(2) J. de Hoog, J.-M. Timmermans, D. Ioan-Stroe, M. Swierczynski, J. Jaguemont, S. Goutam, N. Omar, J. V. Mierlo, and P. V. D. Bossche, "Combined cycling and calendar capacity fade modeling of a Nickel-Manganese-Cobalt Oxide Cell with real-life profile validation," Applied Energy, vol. 200, pp. 47-61, 2017.

(3) V. Ruiz, "Standards for the performance and durability assessment of electric vehicle batteries," European Comission, 2018.

(4) E. Redondo-Iglesias, P. Venet, and S. Pelissier, "Calendar and cycling ageing combination of batteries in electric vehicles," Microelectronics Reliability, vol. 88-90, pp. 1212-1215, 2018.

(5) US 2015/268307

(6) E. Sarasketa-Zabala et al. "Realistic lifetime prédiction approach for Li-ion batteries", Applied Energy, Elsevier Science Publishers, vol. 162, pages 839-852, 11 novembre 2015.

(7) Jean-Marc Timmermans et al. "Batteries 2020 - Lithium-ion battery first and second life ageing, validated battery models, lifetime modelling and ageing assessment of thermal parameters", 18th European Conférence on Power Electronics and Application (EPE'16 ECCE EUROPE), pages 1 - 23, 5 septembre 2016.

(8) L. Pellegrino et al. "Aging test protocol for Lithium-ion cells", 2019 AEIT International Annual Conférence, pages 1 - 6, 18 septembre 2019.

(9) D. Stroe et al. "Accelerated lifetime testing methodology for lifetime estimation of Lithium-ion batteries used in augmented wind power plants", 2013 IEEE Energy Conversion Congress and Exposition, pages 690-698, 15 septembre 2013.

(10) E. Sarasketa-Zabala et al. "Validation of the methodology for lithium-ion batteries lifetime prognosis", 2013 World Electric Vehicle Symposium and Exhibition (EVS27), pages 1 - 12, 17 novembre 2013.

(11) Mathieur Romani et al. "D-optimal design and experiments applied to lithium battery for ageing model calibration", Energy, Elsevier, vol. 141, pages 2108-2119, 23 novembre 2017.

(12) A. Eddahech et al. "Strategy for lithium-ion battery performance improvement during power cycling", IECON 2013 - 39th Annual Conférence of the IEEE Industrial Electronics Society, pages 6806 - 6811, 10 novembre 2013.

**Revendications**

1. Procédé d'étalonnage d'un modèle d'estimation du vieillissement d'accumulateurs électrochimiques (AE), comprenant les étapes suivantes :

   a) soumettre des accumulateurs électrochimiques à au moins une première phase (PV1) de vieillissement pendant laquelle ils sont soumis à un premier type de sollicitation (S1), un test de performance (TP) desdits accumulateurs étant réalisé après ladite ou chaque dite première phase ;
   b) à partir des résultats du ou des tests de performance effectués lors de l'étape précédente, estimer des paramètres d'un premier modèle élémentaire (ME1) de vieillissement au moyen d'un système de traitement numérique (ORD) ;
   c) soumettre les accumulateurs électrochimiques à au moins une deuxième phase de vieillissement (PV2), ladite ou chaque dite deuxième phase de vieillissement comprenant une période pendant laquelle ils sont soumis audit premier type de sollicitation (S1), suivie d'une période pendant laquelle ils sont soumis à un deuxième type de sollicitation (S2), différent du premier, un test de performance (TP) desdits accumulateurs étant réalisé après ladite ou chaque dite deuxième phase ;
   d) à partir des résultats du ou des tests de performance effectués lors de l'étape précédente, estimer des paramètres d'un deuxième modèle élémentaire (ME2) de vieillissement au moyen dudit ou d'un autre système de traitement numérique (ORD) ; **caractérisé en ce que** le modèle d'estimation du vieillissement (MV) d'accumulateurs électrochimiques comprend le premier (ME1) et le deuxième (ME2) modèle élémentaire.

2. Procédé selon la revendication 1 dans lequel, lors de l'étape a), les accumulateurs électrochimiques sont soumis à une pluralité de premières phases de vieillissement successives et, lors de l'étape c), ils sont soumis à une pluralité de deuxièmes phases de vieillissement successives..

3. Procédé selon la revendication 1 dans lequel chaque dite première phase de vieillissement et/ou chaque dite deuxième phase de vieillissement comprend également une période de recharge (CH).

4. Procédé selon l'une quelconque des revendications précédentes dans lequel le premier type de sollicitation correspond au type de sollicitation qui, dans un profil d'usage déterminé, correspond à la contribution quantitativement la plus importante au vieillissement des accumulateurs électrochimiques et le deuxième type de sollicitation correspond au type de sollicitation qui, dans un profil d'usage déterminé, correspond à la deuxième contribution quantitativement la plus importante au vieillissement des accumulateurs électrochimiques.

5. Procédé selon l'une quelconque des revendications précédentes dans lequel le premier type de sollicitation correspond à un vieillissement calendaire et le deuxième type de sollicitation correspond à un premier régime d'utilisation.

6. Procédé selon la revendication 4 comprenant également une étape préalable d'estimation des contributions au vieillissement des accumulateurs électrochimiques de différents types de sollicitations, dans un profil d'usage déterminé.

**7.** Procédé selon l'une quelconque des revendications précédentes comprenant également les étapes suivantes :

d) soumettre les accumulateurs électrochimiques à au moins une troisième phase de vieillissement (PV3), ladite ou chaque dite troisième phase de vieillissement comprenant une période pendant lesquelles ils sont soumis audit premier type de sollicitation (S1), suivie d'une période pendant lesquelles ils sont soumis audit deuxième type de sollicitation (S2), puis d'une période pendant lesquelles ils sont soumis à un troisième type de sollicitation (S3), un test de performance (TP) desdits accumulateurs étant réalisé après ladite ou chaque dite troisième phase ;
e) à partir des résultats du ou des tests de performance effectués lors de l'étape précédente, estimer des paramètres d'un troisième modèle élémentaire (ME3) de vieillissement au moyen dudit ou d'un autre système de traitement numérique ;

le modèle d'estimation vieillissement d'accumulateurs électrochimiques comprenant le premier, le deuxième et le troisième modèles élémentaires.

**8.** Procédé selon la revendication 7 dans lequel les accumulateurs électrochimiques sont des accumulateurs de véhicules électriques (VE), le premier régime correspondant à une utilisation sur des trajets dits courts, ne dépassant une longueur prédéfinie, et le deuxième régime correspondant à une utilisation sur des trajets dits longs, dépassant ladite longueur prédéfinie.

**9.** Procédé selon l'une quelconque des revendications précédentes dans lequel les phases de vieillissement successives sont répétées pour différentes conditions d'utilisation ou stockage, les modèles élémentaires de vieillissement étant adaptés pour calculer une grandeur représentative d'un vieillissement d'un accumulateur électrochimique en fonction desdites conditions d'utilisation et du temps.

**10.** Procédé selon la revendication 9 dans lequel lesdites différentes conditions d'utilisation ou stockage sont définies par au moins une température et un état de charge initial.

**11.** Procédé selon la revendication 10 dans lequel, pour au moins un dit type de sollicitation, lesdites différentes conditions d'utilisation ou stockage sont également définies par une puissance de décharge ou de charge et une profondeur de décharge.

**12.** Procédé selon la revendication 5, ou l'une quelconque des revendications 6 à 11 lorsqu'elle dépend de la revendication 5, dans lesquels tous les modèles élémentaires de vieillissement présentent une même dépendance du temps, déterminée lors de l'étape b).

**13.** Procédé selon l'une quelconques des revendications précédentes, comprenant également une étape de détermination de la contribution individuelle d'au moins un régime d'utilisation par différence entre deux modèles élémentaires.

**14.** Procédé selon l'une quelconque des revendications précédentes dans lequel lesdits accumulateurs électrochimiques sont de type Li-ion.

**15.** Procédé d'estimation du vieillissement d'un accumulateur électrochimique (AE) au moyen d'un modèle (MV) obtenu au moyen d'un procédé d'étalonnage selon l'une des revendications précédentes comprenant les étapes suivantes :

I) déterminer un type de sollicitation, utilisé lors de l'étalonnage du modèle (MV), auquel est soumis l'accumulateur et sélectionner le modèle élémentaire correspondant ;
II) estimer le vieillissement dudit accumulateur par application du modèle élémentaire sélectionné ;

lesdites étapes étant mises en oeuvre par un système de gestion de batterie (BMS).

**Patentansprüche**

1. Verfahren zur Kalibrierung eines Modells zur Alterungsschätzung von elektrochemischen Akkumulatoren (AE), umfassend die folgenden Schritte:

   a) Unterwerfen von elektrochemischen Akkumulatoren mindestens einer ersten Alterungsphase (PV1), während welcher sie einer ersten Art von Spannung (S1) unterworfen werden, wobei ein Leistungstest (TP) der Akkumulatoren nach der oder jeder ersten Phase ausgeführt wird,
   b) anhand der Ergebnisse des oder der Leistungstests, die während des vorhergehenden Schrittes durchgeführt werden, Schätzen von Parametern eines ersten elementaren Alterungsmodells (ME1) mittels eines digitalen Verarbeitungssystems (ORD);
   c) Unterwerfen der elektrochemischen Akkumulatoren mindestens einer zweiten Alterungsphase (PV2), wobei die oder jede zweite Alterungsphase einen Zeitraum umfasst, während welchem sie der ersten Art von Spannung (S1) unterworfen werden, gefolgt von einem Zeitraum, während welchem sie einer zweiten Art von Spannung (S2) unterworfen werden, die sich von der ersten Art unterscheidet, wobei ein Leistungstest (TP) der Akkumulatoren nach der oder jeder zweiten Phase ausgeführt wird;
   d) anhand der Ergebnisse des oder der Leistungstests, die während des vorhergehenden Schrittes durchgeführt werden, Schätzen von Parametern eines zweiten elementaren Alterungsmodells (ME2) mittels des oder eines anderen digitalen Verarbeitungssystems (ORD);

   **dadurch gekennzeichnet, dass** das Alterungsschätzungsmodell (MV) von elektrochemischen Akkumulatoren das erste (ME1) und das zweite (ME2) elementare Modell umfasst.

2. Verfahren nach Anspruch 1, wobei die elektrochemischen Akkumulatoren während des Schrittes a) einer Vielzahl von ersten aufeinanderfolgenden Alterungsphasen unterworfen werden und sie während des Schrittes c) einer Vielzahl von zweiten aufeinanderfolgenden Alterungsphasen unterworfen werden.

3. Verfahren nach Anspruch 1, wobei jede erste Alterungsphase und/oder jede zweite Alterungsphase außerdem einen Aufladungszeitraum (CH) umfasst.

4. Verfahren nach einem der vorhergehenden Ansprüche, wobei die erste Art von Spannung der Art von Spannung entspricht, die in einem bestimmten Gebrauchsprofil dem quantitativ größten Beitrag zur Alterung der elektrochemischen Akkumulatoren entspricht, und die zweite Art von Spannung der Art von Spannung entspricht, die in einem bestimmten Gebrauchsprofil dem zweiten quantitativ größten Beitrag zur Alterung der elektrochemischen Akkumulatoren entspricht.

5. Verfahren nach einem der vorhergehenden Ansprüche, wobei die erste Art von Spannung einer kalendarischen Alterung entspricht und die zweite Art von Spannung einer ersten Nutzungsbetriebsart entspricht.

6. Verfahren nach Anspruch 4, außerdem umfassend einen vorausgehenden Schritt des Schätzens der Beiträge zur Alterung der elektrochemischen Akkumulatoren von verschiedenen Arten von Spannungen in einem bestimmten Gebrauchsprofil.

7. Verfahren nach einem der vorhergehenden Ansprüche, außerdem umfassend die folgenden Schritte:

   d) Unterwerfen der elektrochemischen Akkumulatoren mindestens einer dritten Alterungsphase (PV3), wobei die oder jede dritte Alterungsphase einen Zeitraum umfasst, während welchem sie der ersten Art von Spannung (S1) unterworfen werden, gefolgt von einem Zeitraum, während welchem sie der zweiten Art von Spannung (S2) unterworfen werden, dann von einem Zeitraum, während welchem sie einer dritten Art von Spannung (S3) unterworfen werden, wobei ein Leistungstest (TP) der Akkumulatoren nach der oder jeder dritten Phase ausgeführt wird,
   e) anhand der Ergebnisse des oder der Leistungstests, die während des vorhergehenden Schrittes durchgeführt werden, Schätzen von Parametern eines dritten elementaren Alterungsmodells (ME3) mittels des oder eines anderen digitalen Verarbeitungssystems;

   wobei das Alterungsschätzungsmodell von elektrochemischen Akkumulatoren das erste, das zweite und das dritte elementare Modell umfasst.

8. Verfahren nach Anspruch 7, wobei die elektrochemischen Akkumulatoren Akkumulatoren von Elektrofahrzeugen (VE) sind, wobei die erste Betriebsart einer Nutzung auf als kurz bezeichneten Strecken entspricht, die eine vordefinierte Länge nicht überschreiten, und die zweite Betriebsart einer Nutzung auf als lang bezeichneten Strecken entspricht, die die vordefinierte Länge überschreiten.

9. Verfahren nach einem der vorhergehenden Ansprüche, wobei die aufeinanderfolgenden Alterungsphasen für verschiedene Nutzungs- oder Lagerungsbedingungen wiederholt werden, wobei die elementaren Alterungsmodelle zum Berechnen einer Größe, die für eine Alterung eines elektrochemischen Akkumulators steht, in Abhängigkeit der Nutzungsbedingungen und der Zeit angepasst werden.

10. Verfahren nach Anspruch 9, wobei die verschiedenen Nutzungs- oder Lagerungsbedingungen durch mindestens eine Temperatur und einen ursprünglichen Aufladungszustand definiert werden.

11. Verfahren nach Anspruch 10, wobei bei mindestens einer der Arten von Spannung die verschiedenen Nutzungs- oder Lagerungsbedingungen außerdem durch eine Entladungs- oder Aufladungsleistung und eine Entladungstiefe definiert werden.

12. Verfahren nach Anspruch 5 oder einem der Ansprüche 6 bis 11, wenn er von Anspruch 5 abhängt, wobei alle elementaren Alterungsmodelle eine gleiche Abhängigkeit von der Zeit aufweisen, die während des Schrittes b) bestimmt wird.

13. Verfahren nach einem der vorhergehenden Ansprüche, außerdem umfassend einen Schritt des Bestimmens des individuellen Beitrags mindestens einer Nutzungsbetriebsart durch die Differenz zwischen zwei elementaren Modellen.

14. Verfahren nach einem der vorhergehenden Ansprüche, wobei die elektrochemischen Akkumulatoren vom Li-Ionen-Typ sind.

15. Verfahren zur Alterungsschätzung eines elektrochemischen Akkumulators (AE) mittels eines Modells (MV), das mittels eines Verfahrens zur Kalibrierung nach einem der vorhergehenden Ansprüche erhalten wird, umfassend die folgenden Schritte:

   I) Bestimmen einer Art von Spannung, die bei der Kalibrierung des Modells (MV) genutzt wird, der der Akkumulator unterworfen wird, und Auswählen des entsprechenden elementaren Modells;
   II) Schätzen der Alterung des Akkumulators durch Anwenden des ausgewählten elementaren Modells;

   wobei die Schritte durch ein Batterieverwaltungssystem (BMS) ausgeführt werden.


**Claims**

1. A method for calibrating a model for estimating the ageing of electrochemical accumulators (AE), comprising the following steps of:

   a) subjecting electrochemical accumulators to at least one first ageing phase (PV1), during which they experience a first type of stress (S1), with a performance test (TP) testing the performance of said accumulators being carried out after said first phase or each of said first phases;
   b) estimating, based on the results of the one or more performance tests performed during the previous step, parameters of a first elementary ageing model (ME1) by means of a digital processing system (ORD);
   c) subjecting the electrochemical accumulators to at least one second ageing phase (PV2), with said second ageing phase or each of said second ageing phases comprising a period during which they experience said first type of stress (S1), followed by a period during which they experience a second type of stress (S2), different from the first, with a performance test (TP) testing the performance of said accumulators being carried out after said second phase or each of said second phases;
   d) estimating, based on the results of the one or more performance tests performed during the previous step, parameters of a second elementary ageing model (ME2) by means of said digital processing system or of another digital processing system (ORD);

**characterised in that** the model (MV) for estimating the ageing of electrochemical accumulators comprises the first (ME1) and the second (ME2) elementary model.

2. The method according to claim 1, wherein, during step a), the electrochemical accumulators undergo a plurality of successive first ageing phases and, during step b), they undergo a plurality of successive second ageing phases.

3. The method according to claim 1, wherein each of said first ageing phases and/or each of said second ageing phases also comprises a recharge period (CH).

4. The method according to any one of the preceding claims, wherein the first type of stress corresponds to the type of stress that, in a determined usage profile, corresponds to the quantitatively greatest contribution to the ageing of the electrochemical accumulators and the second type of stress corresponds to the type of stress that, in a determined usage profile, corresponds to the second quantitatively greatest contribution to the ageing of the electrochemical accumulators.

5. The method according to any one of the preceding claims, wherein the first type of stress corresponds to calendar ageing and the second type of stress corresponds to a first usage regime.

6. The method according to claim 4, also comprising a prior step of estimating the contributions to the ageing of the electrochemical accumulators of various types of stresses, in a determined usage profile.

7. The method according to any one of the preceding claims, also comprising the following steps of:

   d) subjecting the electrochemical accumulators to at least one third ageing phase (PV3), with said third ageing phase or each of said third ageing phases comprising a period during which they experience said first type of stress (S1), followed by a period during which they experience said second type of stress (S2), then a period during which they experience a third type of stress (S3), with a performance test (TP) for testing the performance of said accumulators being carried out after said third phase or each of said third phases;
   e) estimating, based on the results of the one or more performance tests performed during the previous step, parameters of a third elementary ageing model (ME3) by means of said digital processing system or of another digital processing system;

   with the model for estimating the ageing of electrochemical accumulators comprising the first, the second and the third elementary models,

8. The method according to claim 7, wherein the electrochemical accumulators are accumulators of electric vehicles (VE), with the first regime corresponding to use on journeys, called short journeys, not exceeding a predefined length, and the second regime corresponding to use on journeys, called long journeys, exceeding said predefined length.

9. The method according to any one of the preceding claims, wherein the successive ageing phases are repeated for various usage or storage conditions, with the elementary ageing models being adapted to compute a quantity representing ageing of an electrochemical accumulator as a function of said usage conditions and of time.

10. The method according to claim 9, wherein said various usage or storage conditions are defined by at least a temperature and an initial charge state.

11. The method according to claim 10, wherein, for at least one of said types of stress, said various usage or storage conditions are also defined by a discharge or charge power and a discharge depth.

12. The method according to claim 5, or any one of claims 6 to 11 when dependent on claim 5, wherein all the elementary ageing models have one and the same time dependence, determined during step b).

13. The method according to any one of the preceding claims, also comprising a step of determining the individual contribution of at least one usage regime by the difference between two elementary models.

14. The method according to any one of the preceding claims, wherein said electrochemical accumulators are of the Li-ion type.

15. A method for estimating the ageing of an electrochemical accumulator (AE) by means of a model (MV) obtained by means of a calibration method according to any of the preceding claims, comprising the following steps of:

I) determining a type of stress, used when calibrating the model, experienced by the accumulator and selecting the corresponding elementary model;
II) estimating the ageing of said accumulator by applying the selected elementary model;

with said steps being implemented by a battery management system (BMS).

FIG.1

FIG.2

FIG.3

PV1

S1

Reprendre pour
une durée
prédéterminée

TP

PrV1

| Calendaire (30 jours) | **Checkup** |

S2

CH

TP

PrV2

S1

Reprendre pour une durée prédéterminée

| Calendaire (5h) | Décharge type court trajet | Charge | **Checkup** |

Reprendre pour un nombre de cycle
prédéterminé

PV2

PrV3

Reprendre pour une durée prédéterminée

| Calendaire (5h) | Décharge type court trajet | Décharge type long trajet | Charge | **Checkup** |

Reprendre pour un nombre de cycle prédéterminé

PV3   S1

CH

TP

S2

S3

# FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015268307 A

**Littérature non-brevet citée dans la description**

- **WAYNE NELSON.** Accelerated Testing. Wiley, 1991
- **J. DE HOOG ; J.-M. TIMMERMANS ; D. LOAN-STROE ; M. SWIERCZYNSKI ; J. JAGUEMONT ; S. GOUTAM ; N. OMAR ; J. V. MIERLO ; P. V. D. BOSSCHE.** Combined cycling and calendar capacity fade modeling of a Nickel-Manganese-Cobalt Oxide Cell with real-life profile validation. *Applied Energy,* 2017, vol. 200, 47-61
- **V. RUIZ.** Standards for the performance and durability assessment of electric vehicle batteries. European Comission, 2018
- **E. REDONDO-LGLESIAS ; P. VENET ; S. PELISSIER.** Calendar and cycling ageing combination of batteries in electric vehicles. *Microelectronics Reliability,* 2018, vol. 88 (90), 1212-1215
- Realistic lifetime prédiction approach for Li-ion batteries. **E. SARASKETA-ZABALA et al.** Applied Energy. Elsevier Science Publishers, 11 Novembre 2015, vol. 162, 839-852
- **JEAN-MARC TIMMERMANS et al.** Batteries 2020 - Lithium-ion battery first and second life ageing, validated battery models, lifetime modelling and ageing assessment of thermal parameters. *18th European Conférence on Power Electronics and Application (EPE'16 ECCE EUROPE,* 05 Septembre 2016, 1-23
- **L. PELLEGRINO et al.** Aging test protocol for Lithium-ion cells. *2019 AEIT International Annual Conférence,* 18 Septembre 2019, 1-6
- **D. STROE et al.** Accelerated lifetime testing methodology for lifetime estimation of Lithium-ion batteries used in augmented wind power plants. *2013 IEEE Energy Conversion Congress and Exposition,* 15 Septembre 2013, 690-698
- **E. SARASKETA-ZABALA et al.** Validation of the methodology for lithium-ion batteries lifetime prognosis. *2013 World Electric Vehicle Symposium and Exhibition (EVS27),* 17 Novembre 2013, 1-12
- D-optimal design and experiments applied to lithium battery for ageing model calibration. **MATHIEUR ROMANI et al.** Energy. Elsevier, 23 Novembre 2017, vol. 141, 2108-2119
- **A. EDDAHECH et al.** Strategy for lithium-ion battery performance improvement during power cycling. *IECON 2013 - 39th Annual Conférence of the IEEE Industrial Electronics Society,* 10 Novembre 2013, 6806-6811